# EUROPEAN PATENT APPLICATION

(11) **EP 4 528 831 A1**
(43) Date of publication of application: **26.03.2025**
(21) Application number: 24161451.0
(22) Date of filing: 05.03.2024
(51) Int. Cl.: H01L 33/16, H01L 33/50, H01L 33/54, H01L 25/075, H01L 25/16, H01L 33/56

(54) **LIGHT EMITTING DEVICE AND DISPLAY APPARATUS INCLUDING THE SAME**

(30) Priority: 21.09.2023 KR 20230126404
(71) Applicant: Samsung Electronics Co., Ltd., Suwon-si, Gyeonggi-do 16677 (KR)
(72) Inventor: HAN, Joohun, 18448 Hwaseong-si (KR); CHOI, Junhee, 18448 Hwaseong-si (KR); KIM, Nakhyun, 18448 Hwaseong-si (KR); KIM, Joosung, 16678 Suwon-si (KR); KIM, Taegon, 16678 Suwon-si (KR)
(74) Representative: Elkington and Fife LLP

(57) **Abstract**

A light emitting device includes a semiconductor light emitting structure including, a first semiconductor layer including a plurality of pores, a light emitting layer provided on the first semiconductor layer, and a second semiconductor layer provided on the light emitting layer, a plurality of quantum dots provided in the plurality of pores, and an external passivation layer at least partially surrounding a sidewall of the semiconductor light emitting structure, where the plurality of quantum dots are provided between the plurality of pores and the external passivation layer.

## Description

### FIELD OF THE INVENTION

The disclosure relates to a light emitting device and a display apparatus including the light emitting device.

### BACKGROUND OF THE INVENTION

Light emitting diodes (LEDs) are known as the next-generation light sources due to their advantages such as long lifespan, low power consumption, fast response speed, and environmental friendliness compared to conventional light sources. Because of these advantages, the industrial demand for LEDs is increasing. LEDs have been generally applied and used in various products such as lighting devices and backlights of display apparatuses.

Recently, micro units or nano units of micro LEDs using group II-VI or group III-V compound semiconductors have been developed. In addition, micro LED displays including micro LEDs directly used as light emitting devices of display pixels have been developed. However, when LEDs are miniaturized to micro units or nano units as described above, the luminous efficiency of the LEDs may be reduced due to a surface defect.

### SUMMARY OF THE INVENTION

Provided are a light emitting device capable of emitting light of a wavelength different from a wavelength of light generated in a light emitting layer and a display apparatus including the light emitting device.

Further provided are a light emitting device with improved luminous efficiency and a display apparatus including the light emitting device.

Additional aspects will be set forth in part in the description which follows and, in part, will be apparent from the description, or may be learned by practice of the presented embodiments of the disclosure.

According to an aspect of the disclosure, a light emitting device may include a semiconductor light emitting structure including, a first semiconductor layer including a plurality of pores, a light emitting layer provided on the first semiconductor layer, and a second semiconductor layer provided on the light emitting layer, a plurality of quantum dots provided in the plurality of pores, and an external passivation layer at least partially surrounding a sidewall of the semiconductor light emitting structure, where the plurality of quantum dots are provided between the plurality of pores and the external passivation layer.

The light emitting device may include an internal passivation layer at least partially surrounding the sidewall of the semiconductor light emitting structure and provided on inner surfaces of the plurality of pores, where the external passivation layer at least partially surrounds a sidewall of the internal passivation layer and the plurality of quantum dots are provided between the internal passivation layer and the external passivation layer.

The internal passivation layer may include an insulating crystal having an epitaxial structure.

The internal passivation layer may include at least one of Al₂O₃, HfAlOₓ, HfO₂, SiO₂, TiO₂, ZrO₂, AIN, Si₃N₄, Ta₂O₅, and AlON.

The internal passivation layer may have a lattice matching epitaxy relationship or a domain matching epitaxy relationship with the semiconductor light emitting structure.

A thickness of the internal passivation layer may be about 0.1 nm or more and about 12 nm or less.

The internal passivation layer may include a first internal passivation layer at least partially surrounding the sidewall of the semiconductor light emitting structure and a second internal passivation layer at least partially surrounding a sidewall of the first internal passivation layer, where the first internal passivation layer contacts an outer surface of the semiconductor light emitting structure, and where the second internal passivation layer contacts the first internal passivation layer, at least one quantum dot of the plurality of quantum dots, and the external passivation layer.

An energy band gap of the first internal passivation layer may be greater than an energy band gap of the semiconductor light emitting structure and an energy band gap of the second internal passivation layer may be greater than or equal to the energy band gap of the first internal passivation layer.

The light emitting layer may be configured to generate first light of a first wavelength, and where the plurality of quantum dots are configured to absorb the first light of the first wavelength and emit second light of a second wavelength that is longer than the first wavelength.

The internal passivation layer and the external passivation layer may be configured as a wavelength selective transmission layer that selectively reflects the first light and selectively transmits the second light.

The external passivation layer may include a first external passivation layer at least partially surrounding the sidewall of the semiconductor light emitting structure and a second external passivation layer at least partially surrounding a sidewall of the first external passivation layer.

The first external passivation layer and the second external passivation layer may be configured as a wavelength selective transmission layer that selectively reflects the first light and selectively transmits the second light.

The external passivation layer may include a plurality of first external passivation layers and a plurality of second external passivation layers that are alternately provided, and the plurality of first external passivation layers may have different refractive indices from the plurality of second external passivation layers.

The external passivation layer may be a distributed Bragg reflector configured to selectively reflect the first light and selectively transmit the second light.

The external passivation layer may include a material capable of being deposited at a temperature of less than 180 °C.

The external passivation layer may include at least one of Al₂O₃, HfO₂, SiO₂, TiO₂, ZrO₂, AlN, Si₃N₄, Ta₂O₅, and AlON.

A thickness of the external passivation layer may be about 1 nm or more and about 100 nm or less.

The external passivation layer may at least partially fill an inside of each of the plurality of pores of the first semiconductor layer.

According to an aspect of the disclosure, a display apparatus may include a first light emitting device, a second light emitting device, and a third light emitting device that are configured to emit light of different wavelengths, where the third light emitting device includes a semiconductor light emitting structure including a first semiconductor layer including a plurality of pores, a light emitting layer provided on the first semiconductor layer, and a second semiconductor layer provided on the light emitting layer, a plurality of quantum dots provided in the plurality of pores, and an external passivation layer at least partially surrounding a sidewall of the semiconductor light emitting structure, where the plurality of quantum dots are provided between the plurality of pores and the external passivation layer, where a light emitting layer of the first light emitting device and the light emitting layer of the third light emitting device are configured to generate first light of a first wavelength, and where the plurality of quantum dots are configured to absorb the first light of the first wavelength generated by the light emitting layer of the third light emitting device and emit second light of a second wavelength that is longer than the first wavelength.

The display apparatus may include a substrate, where a sidewall of the semiconductor light emitting structure of the third light emitting device faces an upper surface of the substrate.

According to an aspect of the disclosure, a display apparatus may include a substrate, a driving device layer on the substrate, and a display apparatus layer on the driving device layer, where the display apparatus layer includes a first light emitting device corresponding to a first sub pixel and configured to emit first light of a first wavelength and a second light emitting device corresponding to a second sub pixel and configured to generate light of the first wavelength and emit second light of a second wavelength that is different from the first wavelength, where the second light emitting device includes a semiconductor light emitting structure comprising a plurality of pores and a plurality of quantum dots provided in the plurality of pores, and where the plurality of quantum dots are configured to absorb the light of the first wavelength generated by the second light emitting device and emit the second light of the second wavelength.

A sidewall of the second light emitting device may face an upper surface of the driving device layer.

The second light emitting device may include an external passivation layer at least partially surrounding a sidewall of the semiconductor light emitting structure, such that the plurality of quantum dots are provided between the plurality of pores and the external passivation layer.

The external passivation layer may contact an upper surface of the driving device layer.

Each of the first light emitting device and the second light emitting device may include a sidewall that contacts an upper surface of the driving device layer.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1 is a cross-sectional view illustrating a structure of a light emitting device according to an embodiment;
FIGS. 2A, 2B, 2C, 2D, 2E, 2F and 2G are cross-sectional views illustrating a method of manufacturing the light emitting device shown in FIG. 1 according to an embodiment;
FIG. 3 is a transverse cross-sectional view illustrating pores formed in a first semiconductor layer during a manufacturing process shown in FIG. 2D according to an embodiment;
FIG. 4 is a transverse cross-sectional view illustrating an internal passivation layer formed along surface of the pores of the first semiconductor layer during a manufacturing process shown in FIG. 2E according to an embodiment;
FIG. 5 is a transverse cross-sectional view illustrating a plurality of quantum dots within the pores in the first semiconductor layer during a manufacturing process shown in FIG. 2F according to an embodiment;
FIG. 6 is a transverse cross-sectional view illustrating an external passivation layer formed to surround the first semiconductor layer during a manufacturing process shown in FIG. 2G according to an embodiment;
FIG. 7 is a cross-sectional view illustrating a structure of a light emitting device according to an embodiment;
FIG. 8 is a transverse cross-sectional view illustrating a structure of the light emitting device shown in FIG. 7 according to an embodiment;
FIG. 9 is a cross-sectional view illustrating a structure of an external passivation layer of a light emitting device according to an embodiment;
FIG. 10 is a cross-sectional view illustrating a schematic structure of a light emitting device according to an embodiment;
FIG. 11 is a transverse-sectional view illustrating a structure of the light emitting device shown in FIG. 10 according to an embodiment;
FIG. 12 is a cross-sectional view illustrating a light emitting apparatus including a light emitting device according to an embodiment;
FIG. 13 is a cross-sectional view illustrating a display apparatus including light emitting devices according to an embodiment;
FIG. 14 is a block diagram of an electronic apparatus according to an embodiment;
FIG. 15 is a diagram illustrating an example in which a display apparatus is applied to a mobile device according to an embodiment;
FIG. 16 is a diagram illustrating an example in which a display apparatus is applied to a vehicle according to an embodiment;
FIG. 17 is a diagram illustrating an example in which a display apparatus is applied to augmented reality glasses or virtual reality glasses according to an embodiment;
FIG. 18 is a diagram illustrating an example in which a display apparatus is applied to a signage according to an embodiment; and
FIG. 19 is a diagram illustrating an example in which a display apparatus is applied to a wearable display according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, a light emitting device and a display apparatus including the light emitting device will be described in detail with reference to the accompanying drawings. The embodiments described below are merely exemplary, and various modifications are possible from these embodiments. In the following drawings, the same reference numerals refer to the same components, and the size of each component in the drawings may be exaggerated for clarity and convenience of description.

In the following description, when a component is referred to as being "above" or "on" another component, it may be directly on an upper, lower, left, or right side of the other component while making contact with the other component or may be above an upper, lower, left, or right side of the other component without making contact with the other component.

Terms such as first, second, etc. may be used to describe various components, but are used only for the purpose of distinguishing one component from another component. These terms do not limit the difference in the material or structure of the components.

The terms of a singular form may include plural forms unless otherwise specified. In addition, when a certain part "includes" a certain component, it means that other components may be further included rather than excluding other components unless otherwise stated.

In addition, terms such as "unit" and "module" described in the specification may indicate a unit that processes at least one function or operation, and this may be implemented as hardware or software, or may be implemented as a combination of hardware and software.

The use of the term "the" and similar designating terms may correspond to both the singular and the plural.

Operations of a method may be performed in an appropriate order unless explicitly described in terms of order. In addition, the use of all illustrative terms (e.g., etc.) is merely for describing technical ideas in detail, and the scope is not limited by these examples or illustrative terms unless limited by the claims.

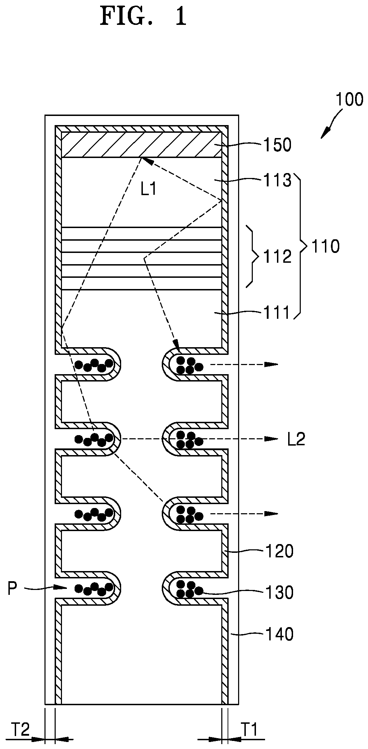

FIG. 1 is a cross-sectional view illustrating a structure of a light emitting device 100 according to an embodiment. Referring to FIG. 1, the light emitting device 100 according to an embodiment may include a semiconductor light emitting structure 110 having a nanorod shape. The semiconductor light emitting structure 110 may include a first semiconductor layer 111, a light emitting layer 112 disposed on the first semiconductor layer 111, and a second semiconductor layer 113 disposed on the light emitting layer 112.

The first semiconductor layer 111 and the second semiconductor layer 113 may include a group II-VI or group III-V compound semiconductor material. For example, each of the first semiconductor layer 111 and the second semiconductor layer 113 may include at least one semiconductor material of InAlGaN, GaN, AlGaN, InGaN, AlN, InN, and AlGaInP. The first semiconductor layer 111 and the second semiconductor layer 113 may serve to provide electrons and holes to the light emitting layer 112. To this end, the first semiconductor layer 111 may be doped with n-type or p-type, and the second semiconductor layer 113 may be doped with a conductivity type that is electrically opposite to the first semiconductor layer 111. For example, the first semiconductor layer 111 may be doped with n-type and the second semiconductor layer 113 may be doped with p-type, or the first semiconductor layer 111 may be doped with p-type and the second semiconductor layer 113 may be doped with n-type. When the first semiconductor layer 111 or the second semiconductor layer 113 is doped with n-type, silicon (Si), germanium (Ge), or tin (Sn) may be used as a dopant, for example. When the first semiconductor layer 111 or the second semiconductor layer 113 is doped with p-type, zinc (Zn) or magnesium (Mg) or may be used as a dopant, for example. The n-type doped first semiconductor layer 111 or second semiconductor layer 113 may provide electrons to the light emitting layer 112, and the p-type doped second semiconductor layer 113 or the first semiconductor layer 111 may provide holes to the light emitting layer 112.

The light emitting layer 112 may include at least one semiconductor material of InAlGaN, GaN, AlGaN, InGaN, AlN, InN, and AlGaInP. The light emitting layer 112 has a quantum well structure in which quantum wells are disposed between barriers. Light may be generated as electrons and holes provided from the first semiconductor layer 111 and the second semiconductor layer 113 are recombined in a quantum well in the light emitting layer 112. A wavelength of light generated from the light emitting layer 112 may be determined according to an energy band gap of a material of the quantum well in the light emitting layer 112. The light emitting layer 112 may have only one quantum well, and also may have a multi-quantum well (MQW) structure in which a plurality of quantum wells and a plurality of barriers are alternately disposed. A thickness of the light emitting layer 112 or the number of quantum wells in the light emitting layer 112 may be appropriately selected in consideration of a driving voltage and luminous efficiency of the light emitting device 100. For example, the thickness of the light emitting layer 112 may be selected to be less than or equal to twice a diameter of the semiconductor light emitting structure 110. The thickness of the light emitting layer 112 is measured in a vertical direction or a height direction of the semiconductor light emitting structure 110.

The semiconductor light emitting structure 110 may have a nanorod shape having a very small size on a nano-scale or a micro-scale. For example, the diameter of the semiconductor light emitting structure 110 may be in a range of about 0.05 µm to about 2 µm. The semiconductor light emitting structure 110 having the nanorod shape may have a substantially uniform diameter in the height direction. For example, the first semiconductor layer 111, the light emitting layer 112, the second semiconductor layer 113, and the electrode 150 may have substantially the same diameter. In addition, when a length between a lower surface of the first semiconductor layer 111 and an upper surface of the second semiconductor layer 113, or a length between the lower surface of the first semiconductor layer 111 and the upper surface of an electrode 150 is a height of the semiconductor light emitting structure 110, the height of the semiconductor light emitting structure 110 may be in a range of about 1 µm to about 20 µm. In addition, the semiconductor light emitting structure 110 may have, for example, a large aspect ratio of 3 or more.

In addition, the light emitting device 100 may further include a plurality of quantum dots 130 inserted into the first semiconductor layer 111. To this end, the first semiconductor layer 111 may have a porous structure including a plurality of pores P. The plurality of quantum dots 130 may be disposed inside the plurality of pores P of the first semiconductor layer 111. Neighboring quantum dots among the plurality of quantum dots 130 within each of the pores P may or may not be connected to each other. The quantum dots 130 connected to each other may be ligand-bound. A ratio occupied by the plurality of quantum dots 130 within each of the pores P may be about 80 % or more or about 90 % or more.

The quantum dot 130 is a particle of a certain size having a quantum confinement effect. The quantum dot 130 may include a compound such as, for example, CdSe, CdSe, CdTe, InP, InAs, InSb, PbSe, PbS, PbTe, AlAs, ZnS, ZnSe, ZnTe, graphene, etc. In addition, the quantum dot 130 may have a core-shell structure having a core portion and a shell portion, or may have a particle structure without a shell. The core-shell structure may be a single-shell or multi-shell structure (for example, a double-shell structure).

The quantum dot 130 may absorb light in a specific wavelength band and emit light in a wavelength band longer than the specific wavelength band. A wavelength of light absorbed by the quantum dot 130 may vary depending on a band gap of the quantum dot 130. The band gap of the quantum dot 130 may be mainly determined according to a diameter of the quantum dot 130. For example, the diameter of the quantum dots 130 may be within a range of about 1 nm to about 10 nm such that the quantum dot 130 may be excited by blue light or ultraviolet ray to emit red light or green light. The plurality of quantum dots 130 may have the same diameter, but are not limited thereto.

According to an embodiment, the light emitting layer 112 may be configured to generate first light L1 of a first wavelength. The quantum dot 130 may absorb the first light L1 of the first wavelength and emit a second light L2 of a second wavelength longer than the first wavelength. For example, the first wavelength may include a wavelength band of ultraviolet ray or blue light of about 300 nm or more to about 500 nm or less, and the second wavelength may include a wavelength band of green light, red light, or infrared light of about 500 nm or more to about 780 nm or less. Accordingly, the light emitting layer 112 may generate ultraviolet ray or blue light, and the light emitting device 100 may ultimately emit green light or red light.

When the light emitting layer 112 includes indium (In), the greater the indium (In) content, the longer the wavelength of light emitted from the light emitting layer 112 may be. For example, when indium content of the light emitting layer 112 is about 15 %, the light emitting layer 112 may emit blue light of about 450 nm, when the indium content of the light emitting layer 112 is about 25 %, the light emitting layer 112 may emit green light of about 520 nm, and when the indium content of the light emitting layer 112 is about 35 %, the light emitting layer 112 may emit red light of about 630 nm. Therefore, in some embodiments, the indium content of the light emitting layer 112 may be about 15 % or less.

In the nanorod-shaped semiconductor light emitting structure 110 having a very small size in the nanoscale or microscale, the longer the emission wavelength, the lower the external quantum efficiency (EQE) and internal quantum efficiency (IQE) of the light emitting layer 112 may be. In addition, the more the indium content of the light emitting layer 112, the more the defects due to a lattice mismatch. Therefore, the light emitting layer 112 is configured to generate light of a short wavelength band with relatively high luminous efficiency, and the quantum dots 130 change light of a short wavelength into light of a relatively long wavelength and emit the light. Thus, the luminous efficiency of the light emitting device 100 that emits green light or red light may be improved.

In addition, the light emitting device 100 may further include an internal passivation layer 120 that directly surrounds (i.e., surrounds and directly contacts) a sidewall of the semiconductor light emitting structure 110 and has insulating properties, and an external passivation layer 140 that surrounds a sidewall of the internal passivation layer 120 and the quantum dots 130 and has insulating properties. As described herein, the term "surround" may indicate a full surrounding or at least a partial surrounding of components when considered from various perspectives, as will be understood by one of ordinary skill in the art from the disclosure herein. The internal passivation layer 120 may be omitted. When the internal passivation layer 120 is omitted, the external passivation layer 140 may be disposed to directly surround (i.e., surround and directly contact) the sidewall of the semiconductor light emitting structure 110.

Surface defects due to dangling bonds occur on an outer surface of the semiconductor light emitting structure 110. As a surface to volume ratio increases, dangling bonds increase, which also increases surface defects. The surface defect hinders a flow of current and becomes a factor that deteriorates the luminous efficiency of the light emitting layer 112. The internal passivation layer 120 may be disposed to surround the sidewall of the semiconductor light emitting structure 110, thereby reducing defects due to dangling bonds and increasing the luminous efficiency of the light emitting device 100. For example, the internal passivation layer 120 may include at least one material of Al₂O₃, HfAlOₓ, HfO₂, SiO₂, TiO₂, ZrO₂, AlN, Si₃N₄, Ta₂O₅, and AlON. A thickness T1 of the internal passivation layer 120 may be considered in view of the size of the pore P, and may be, for example, about 0.1 nm or more and about 12 nm or less or about 10 nm or less. Here, the thickness T1 of the internal passivation layer 120 is measured in a horizontal direction (that is, in a radial direction) from the center of the semiconductor light emitting structure 110, and is a distance between inner and outer sidewalls of the internal passivation layer 120.

The internal passivation layer 120 may include an insulating crystal having an epitaxy structure. For example, the internal passivation layer 120 may have a lattice matching epitaxy relationship or a domain matching epitaxy relationship with the semiconductor light emitting structure 110. The lattice matching epitaxy relationship may refer to a relationship in which a lattice constant of the internal passivation layer 120 is substantially equal to a lattice constant of the semiconductor light emitting structure 110. In addition, the domain matching epitaxy relationship may refer to a relationship in which the lattice constant of the internal passivation layer 120 is substantially equal to an integer multiple of the lattice constant of the semiconductor light emitting structure 110 or a relationship in which the lattice constant of the semiconductor light emitting structure 110 is substantially equal to an integer multiple of the lattice constant of the internal passivation layer 120. The lattice constant of the internal passivation layer 120 may not perfectly match the lattice constant of the semiconductor light emitting structure 110 or an integer multiple thereof, and may be within a certain similar range. For example, a difference between the lattice constant of the internal passivation layer 120 and the lattice constant of the semiconductor light emitting structure 110 may be within ±30 % of the lattice constant of the semiconductor light emitting structure 110. In some embodiments, a difference in the lattice constant of the internal passivation layer 120 to the integer multiple of the lattice constant of the semiconductor light emitting structure 110 may be within ±30 % of the integer multiple of the lattice constant of the semiconductor light emitting structure 110. In this case, because atoms located on the outer surface of the semiconductor light emitting structure 110 may mostly bond to atoms of the internal passivation layer 120, dangling bonds on the outer surface of the semiconductor light emitting structure 110 may be reduced, and accordingly, surface defects may be also reduced.

The internal passivation layer 120 may be disposed along the outer surface, such as side surfaces, of the semiconductor light emitting structure 110. In other words, the internal passivation layer 120 may be disposed to surround side surfaces of the first semiconductor layer 111, side surfaces of the light emitting layer 112, and side surfaces of the second semiconductor layer 113. The internal passivation layer 120 may also be disposed within the pores P of the first semiconductor layer 111. For example, a portion of the internal passivation layer 120 facing the first semiconductor layer 111 may be disposed windingly along inner surfaces of the plurality of pores P to cover the inner surfaces. Accordingly, the quantum dots 130 disposed in the pores P may contact the internal passivation layer 120 without directly contacting the first semiconductor layer 111.

The external passivation layer 140 may be configured to protect the quantum dots 130 from an external environment and minimize empty spaces inside the pores P. To this end, the external passivation layer 140 may be disposed to surround the sidewall of the internal passivation layer 120 and at least partially fill the inside of each of the pores P of the first semiconductor layer 111. Accordingly, the plurality of quantum dots 130 in each of the pores P may be disposed between the internal passivation layer 120 and the external passivation layer 140, such that the plurality of quantum dots 130 are surrounded by the internal passivation layer 120 and the external passivation layer 140, and are not exposed to the external environment. When the internal passivation layer 120 is omitted, the external passivation layer 140 may be disposed to surround the sidewall of the semiconductor light emitting structure 110 and at least partially fill the inside of each of the pores P of the first semiconductor layer 111. Accordingly, the plurality of quantum dots 130 in each of the pores P may be disposed between each of the pores P and the external passivation layer 140 and may be surrounded by an inner wall of each of the pores P and the external passivation layer 140. The external passivation layer 140 minimizes the empty space inside each of the pores P, thereby reducing loss due to reflection and scattering of the second light L2 and improving light extraction efficiency.

This external passivation layer 140 may be formed at a temperature of less than about 180 °C to prevent the quantum dots 130 from being damaged during a process of depositing the external passivation layer 140. In other words, the external passivation layer 140 may include a material capable of being deposited at the temperature of less than about 180 °C. For example, the external passivation layer 140 may include at least one material of Al₂O₃, HfO₂, SiO₂, TiO₂, ZrO₂, AlN, Si₃N₄, Ta₂O₅, and AlON. A thickness T2 of the external passivation layer 140 may be sufficiently thick to serve as a protective layer and greater than the thickness T1 of the internal passivation layer 120. For example, the thickness T2 of the external passivation layer 140 may be about 1 nm or more and about 100 nm or less, or about 50 nm or less. Here, the thickness T2 of the external passivation layer 140 is measured in the horizontal direction (that is, in the radial direction) from the center of the semiconductor light emitting structure 110, and is a distance between inner and outer sidewalls of the external passivation layer 140.

In addition, the internal passivation layer 120 and the external passivation layer 140 may be configured to jointly serve as a wavelength selective transmission layer that selectively reflects the first light L1 of the relatively short wavelength generated from the light emitting layer 112 and selectively transmits the second light L2 of the relatively long wavelength emitted from the quantum dot 130. To this end, the internal passivation layer 120 and the external passivation layer 140 may include materials having different refractive indices. In addition, the material and the thickness T1 of the internal passivation layer 120 and the material and the thickness T2 of the external passivation layer 140 may be selected such that an interference phenomenon, which causes the first light L1 (which may include ultraviolet rays or blue light) to be reflected and the second light L2 (which may include green light, red light, or infrared light) to be transmitted, occurs at an interface between the internal passivation layer 120 and the external passivation layer 140.

In addition, the light emitting device 100 may further include an electrode 150 disposed on the upper surface of the semiconductor light emitting structure 110 or the upper surface of the second semiconductor layer 113. The electrode 150 may be configured to reflect incident light into the semiconductor light emitting structure 110. To this end, the electrode 150 may include a material having a high reflectivity with respect to the first light L1 and the second light L2. In addition, the electrode 150 may include a conductive material that may be electrically connected to an electrode pad of an external device, which will be described below. For example, the electrode 150 may include at least one of Ag, Au, Pt, Ni, Cr, and Al, which are materials with excellent reflectivity and conductivity, but is not limited thereto. When the light emitting device 100 is disposed such that the upper portion of the semiconductor light emitting structure 110 is surrounded by the electrode pad of the external device, the electrode 150 may include a transparent conductive material such as ITO.

According to an embodiment, the first light L1 generated in the light emitting layer 112 may be confined within the semiconductor light emitting structure 110 without being emitted to the outside of the semiconductor light emitting structure 110. For example, a portion of the first light L1 generated in the light emitting layer 112 may be directly incident on the quantum dot 130 and converted into the second light L2. A remaining portion of the first light L1 may be reflected by the internal passivation layer 120 and the external passivation layer 140 disposed on the sidewall of the semiconductor light emitting structure 110 or may be reflected by the electrode 150, incident on the quantum dot 130, and converted into the second light L2. The first light L1 is confined within the semiconductor light emitting structure 110 by the internal passivation layer 120 and external passivation layer 140 disposed on the sidewall of the semiconductor light emitting structure 110, as well as the electrode 150 disposed on the upper surface of the semiconductor light emitting structure 110. Thus, most of the first light L1 generated in the light emitting layer 112 may be converted into the second light L2 by the quantum dots 130 while traveling along the inside of the semiconductor light emitting structure 110. Therefore, a high color conversion rate may be achieved. As a result, only the second light L2 converted by the quantum dot 130 may be emitted from the light emitting device 100. For example, the second light L2 may be emitted in the radial direction of the semiconductor light emitting structure 110 through the sidewall of the semiconductor light emitting structure 110.

The light emitting device 100 may further include a transparent contact layer disposed between the second semiconductor layer 113 and the electrode 150. In addition, the light emitting device 100 may further include a buffer layer disposed on the lower surface of the first semiconductor layer 111 and/or a contact layer disposed between the first semiconductor layer 111 and the buffer layer. For example, the buffer layer may include GaAs, and the contact layer may include GaInP or GaAs.

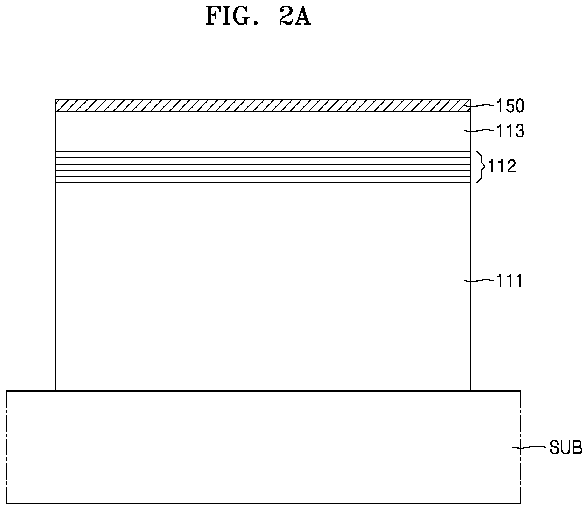

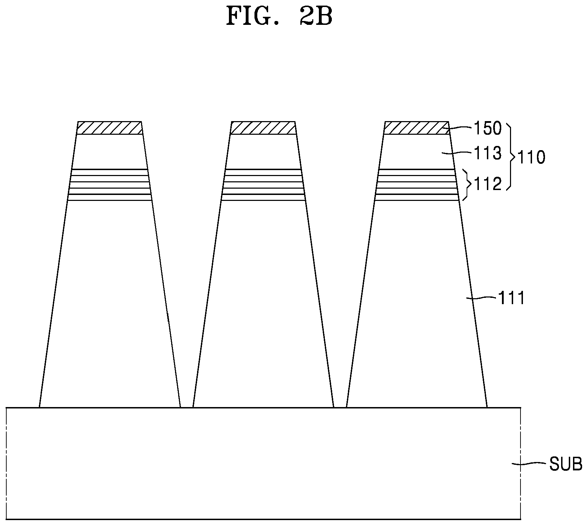

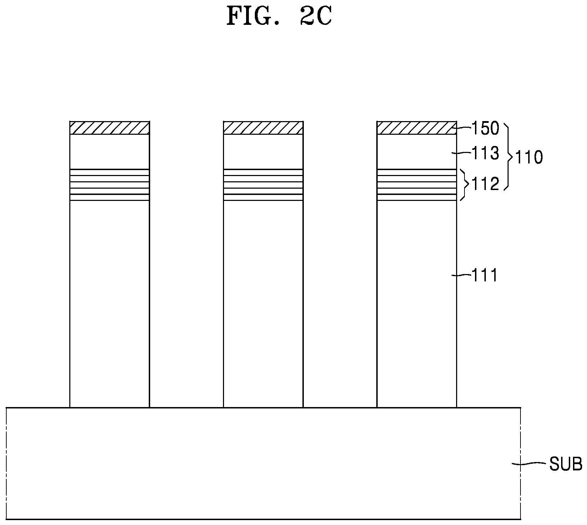

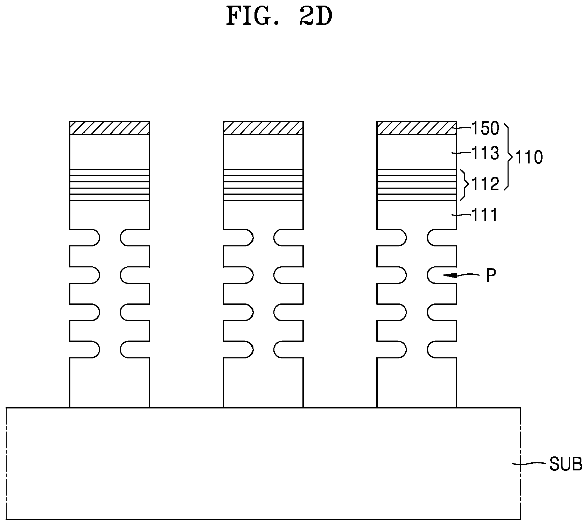

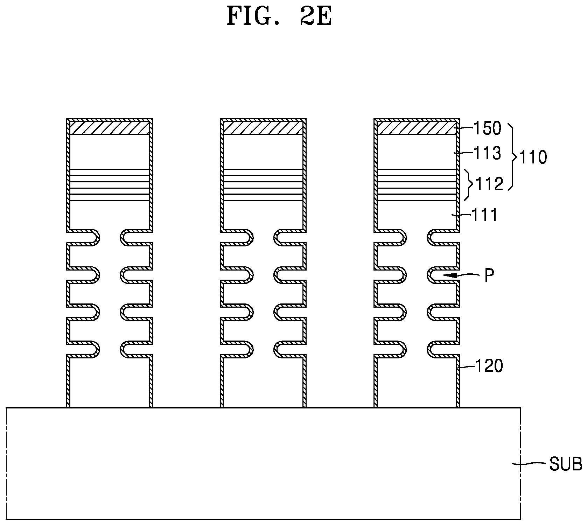

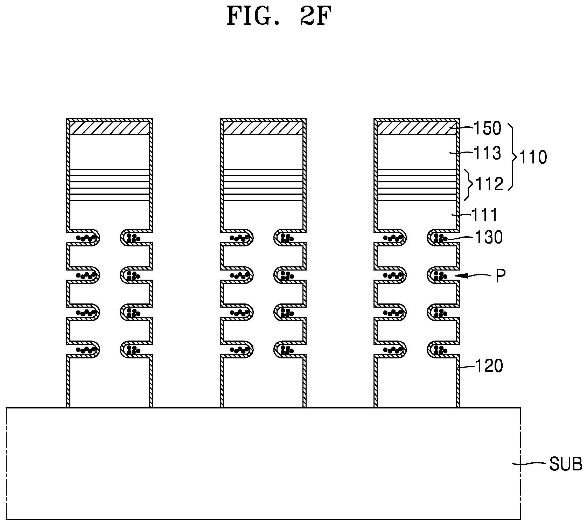

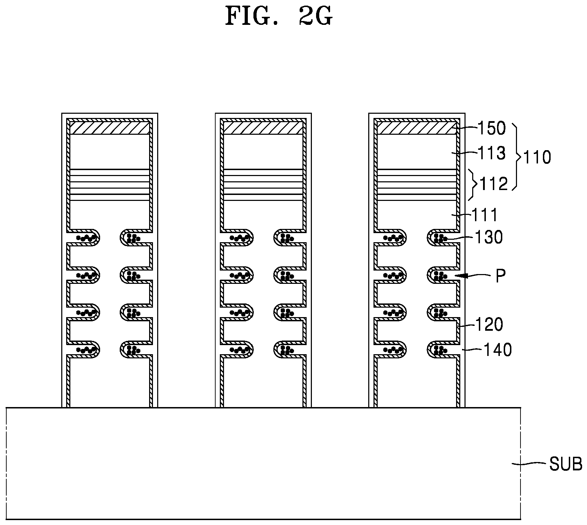

FIGS. 2A, 2B, 2C, 2D, 2E, 2F and 2G are cross-sectional views illustrating a method of manufacturing the light emitting device 100 shown in FIG. 1 according to an embodiment.

Referring first to FIG. 2A, the first semiconductor layer 111, the light emitting layer 112, the second semiconductor layer 113, and the electrode 150 are sequentially grown on a substrate SUB. The first semiconductor layer 111 is grown on the entire upper surface of the substrate SUB, and the light emitting layer 112 is grown on the entire upper surface of the first semiconductor layer 111. In addition, the second semiconductor layer 113 and the electrode 150 may also each be grown to be disposed over the entire upper surface of an underlying layer thereof. FIG. 2A shows that the first semiconductor layer 111 is directly grown on the substrate SUB, but the first semiconductor layer 111 is not limited thereto. For example, a buffer layer may first be grown on the substrate SUB, and then the first semiconductor layer 111 may be grown on the buffer layer. In addition, a contact layer may first be grown on the buffer layer, and then the first semiconductor layer 111 may be grown on the contact layer.

The first semiconductor layer 111 is a single layer including a semiconductor material of a single composition, and the second semiconductor layer 113 is also a single layer including a semiconductor material having the same composition as that of the first semiconductor layer 111. However, the first semiconductor layer 111 and the second semiconductor layer 113 are doped in opposite types. For example, when the first semiconductor layer 111 may be doped with an n-type dopant, the second semiconductor layer 113 may be doped with a p-type dopant. For example, each of the first semiconductor layer 111 and the second semiconductor layer 113 may include at least one semiconductor material of InAlGaN, GaN, AlGaN, InGaN, AlN, InN, and AlGaInP.

The light emitting layer 112 may include at least one semiconductor material of InAlGaN, GaN, AlGaN, InGaN, AlN, InN, and AlGaInP. The semiconductor material of the light emitting layer 112 is not doped. The light emitting layer 112 may include a barrier and a quantum well. For example, when light emitting layer 112 includes AlGaInP, the barrier may include more Al content in AlGaInP than the quantum well. In addition, when compared to the first and second semiconductor layers 111 and 113, the Al content may be the highest in the first and second semiconductor layers 111 and 113, followed by the Al content in the barrier within the light emitting layer 112, and the Al content may be the lowest in the quantum well within the light emitting layer 112. Then, in a conduction band, energy levels of the first and second semiconductor layers 111 and 113 may be the highest, followed by an energy level of the barrier in the light emitting layer 112, and an energy level of the quantum well in the light emitting layer 112 may be the lowest. Even when a semiconductor material other than AlGaInP is used, the light emitting layer 112 may be formed to include the barrier and the quantum well by controlling a composition of the semiconductor material.

Referring to FIG. 2B, the electrode 150, the second semiconductor layer 113, the light emitting layer 112, and the first semiconductor layer 111 may be patterned in the shape of a plurality of nanorods. Accordingly, a plurality of semiconductor light emitting structures 110 in the nanorod shape each including the first semiconductor layer 111, the light emitting layer 112, the second semiconductor layer 113, and the electrode 150 may be formed simultaneously on the substrate SUB. For example, a hard mask having a plurality of openings disposed at regular intervals may be formed on the electrode 150, and areas not covered by the hard mask may be removed by etching using a dry etching method.

The semiconductor light emitting structures 110 formed in FIG. 2B may have a shape having a diameter gradually decreasing in a height direction from the first semiconductor layer 111 to the electrode 150. Referring to FIG. 2C, the diameter of each of the semiconductor light emitting structures 110 may be made uniform in the height direction through a wet process using, for example, a KOH solution. In this process, the hard mask on the electrode 150 may also be removed.

Referring to FIG. 2D, the plurality of pores P may be formed in the sidewall of the first semiconductor layer 111 using an electrochemical etching method. For example, the first semiconductor layer 111 may be porous treated by flowing current to the semiconductor light emitting structure 110 in an acidic aqueous solution. The acidic aqueous solution may include, for example, oxalic acid, nitric acid, sodium nitrate, etc., but is not limited thereto. The density (i.e., porosity) of the pores P of the first semiconductor layer 111 may be adjusted by the voltage applied during an electrochemical etching process, a process time, an acidic aqueous solution, the doping concentration of the first semiconductor layer 111, etc. For example, when porous treatment of the first semiconductor layer 111 is performed by removing silicon (Si) included in the first semiconductor layer 111, a higher doping concentration of silicon (Si) may result in a higher porosity of the first semiconductor layer 111. When the light emitting layer 112 and the second semiconductor layer 113 are not doped with silicon (Si), the light emitting layer 112 and the second semiconductor layer 113 may not be porous treated.

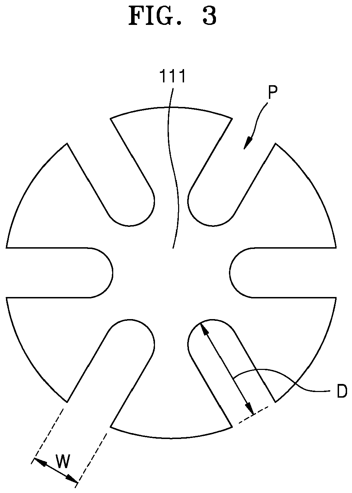

FIG. 3 is a transverse cross-sectional view illustrating pores formed in a first semiconductor layer 111 during a manufacturing process shown in FIG. 2D according to an embodiment. Referring to FIG. 3, the plurality of pores P may be formed from a sidewall surface of the first semiconductor layer 111 toward the center of the first semiconductor layer 111. Each of the pores P may have a size sufficient to contain a plurality of quantum dots therein. For example, a depth D of the pore P may be about 100 nm or more and about 170 nm or less, and a width W of the pore P may be about 20 nm or more and about 80 nm or less.

Referring to FIG. 2E, the internal passivation layer 120 may be formed on an outer surface of each of the semiconductor light emitting structures 110. For example, the internal passivation layer 120 may be formed using an atomic layer deposition (ALD) method within a temperature range of about 250 °C to about 500 °C. For example, the internal passivation layer 120 may be formed by depositing at least one material of Al₂O₃, HfAlOₓ, HfO₂, SiO₂, TiO₂, ZrO₂, AlN, Si₃N₄, Ta₂O₅, and AlON to a thickness of about 0.1 nm or more and about 12 nm or less or about 10 nm or less on the surface of each of the semiconductor light emitting structures 110 using a plasma enhanced ALD (PEALD) or thermal ALD method.

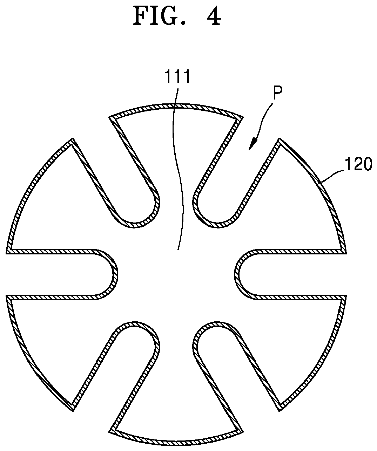

FIG. 4 is a transverse cross-sectional view illustrating the internal passivation layer 120 formed along surface of the pores P of the first semiconductor layer 111 during a manufacturing process shown in FIG. 2E according to an embodiment. Referring to FIG. 4, the internal passivation layer 120 may be provided along an outer surface of the first semiconductor layer 111. The internal passivation layer 120 may also be formed on inner surfaces of the pores P. Accordingly, the outer surface of the first semiconductor layer 111 and the inner surfaces of the pores P may be surrounded by the internal passivation layer 120.

Referring to FIG. 2F, the plurality of quantum dots 130 may be formed in each of the pores P of the first semiconductor layer 111 of the plurality of semiconductor light emitting structures 110. For example, when the plurality of semiconductor light emitting structures 110 are immersed in a solution including the quantum dots 130 and an electrolytic plating method, a photoresist process, an electrophoretic deposition method, etc., are performed, the quantum dots 130 may enter each of the pores P of the first semiconductor layer 111. Among the plurality of quantum dots 130 disposed in each of the pores P of the first semiconductor layer 111, neighboring quantum dots may or may not be connected to each other, and may be disposed in groups in each of the pores P. The quantum dots 130 connected to each other may be ligand-bound. A ratio occupied by the quantum dots 130 within each of the pores P may be about 80 % or more or about 90 % or more. A remaining space in each of the pores P not occupied by the quantum dots 130 may be empty or may be partially filled with a photoresist material. A solvent may be removed after the quantum dots 130 enter each of the pores P, and at this time, a portion of the photoresist material may remain.

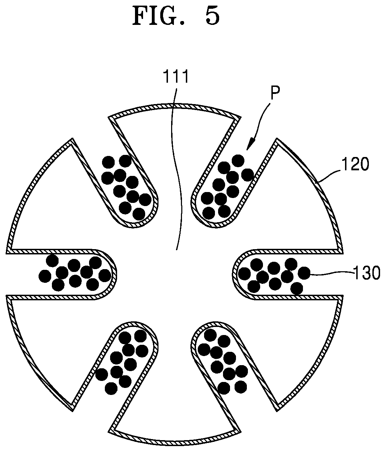

FIG. 5 is a transverse cross-sectional view illustrating the plurality of quantum dots 130 disposed within the pores P of the first semiconductor layer 111 during a manufacturing process shown in FIG. 2F according to an embodiment. Referring to FIG. 5, the plurality of quantum dots 130 may be filled in each of the pores P. An inner surface of each of the pores P is surrounded by the internal passivation layer 120, and thus, the plurality of quantum dots 130 do not directly contact the first semiconductor layer 111. At least one of the plurality of quantum dots 130 may directly contact the internal passivation layer 120.

When the internal passivation layer 120 is omitted, a process shown in FIG. 2E may also be omitted. Then, in the manufacturing process shown in FIG. 2F, the plurality of quantum dots 130 may be disposed in each of the pores P without the internal passivation layer 120 and may directly contact the first semiconductor layer 111.

Referring to FIG. 2G, the external passivation layer 140 may be formed to contact an outer surface of each of the semiconductor light emitting structures 110. That is, the external passivation layer 140 may be formed to contact an outer surface of the internal passivation layer 120. However, when the manufacturing process of the internal passivation layer 120 shown in FIG. 2E is omitted, the external passivation layer 140 may be formed to directly contact the outer surface of each of the semiconductor light emitting structures 110. The external passivation layer 140 may be formed at a temperature of less than 180 °C to prevent the plurality of quantum dots 130 from being damaged. For example, the external passivation layer 140 may be formed by depositing at least one material of Al₂O₃, HfO₂, SiO₂, TiO₂, ZrO₂, AlN, Si₃N₄, Ta₂O₅, and AlON at a thickness of about 1 nm or more and about 100 nm or less or about 50 nm or less on the surface of each of the semiconductor light emitting structures 110. The at least one material may be deposited using a PEALD or thermal ALD method. The external passivation layer 140 formed as described above may be disposed to surround each of the semiconductor light emitting structures 110, the internal passivation layer 120, the plurality of pores P, and the plurality of quantum dots 130.

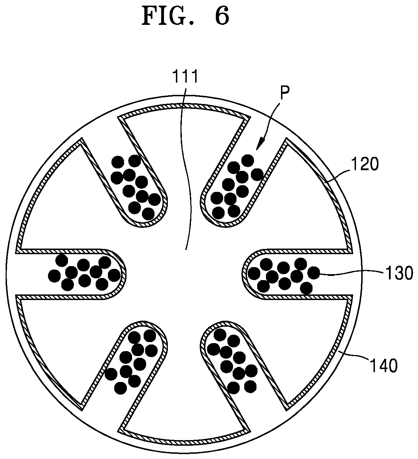

FIG. 6 is a transverse cross-sectional view illustrating the external passivation layer 140 formed to surround the first semiconductor layer 111 during a manufacturing process shown in FIG. 2G according to an embodiment. Referring to FIG. 6, an external passivation layer 140 may be provided to surround an outer surface of the first semiconductor layer 111. The external passivation layer 140 may directly contact the internal passivation layer 120 in areas between the adjacent pores P. Additionally, as shown in FIG. 2G, the external passivation layer 140 may directly contact the internal passivation layer 120 even in an area facing the light emitting layer 112 and the second semiconductor layer 113. However, when the manufacturing process of the internal passivation layer 120 shown in FIG. 2E is omitted, the external passivation layer 140 may directly contact an outer surface of each of the semiconductor light emitting structures 110. The external passivation layer 140 may be disposed to block an entrance of each of the pores P, and therefore, the plurality of quantum dots 130 disposed in each of the pores P may be completely surrounded by the internal passivation layer 120 and the external passivation layer 140 and not exposed to the outside. In addition, the external passivation layer 140 may be partially disposed inside each of the pores P. Then, the external passivation layer 140 may minimize an empty space inside each of the pores P, thereby improving light extraction efficiency The external passivation layer 140 may directly contact portions of the plurality of quantum dots 130 within each of the pores P, and may also directly contact a portion of the internal passivation layer 120 within each of the pores P.

FIG. 2G shows that the internal passivation layer 120 and the external passivation layer 140 cover a sidewall and upper surface of the electrode 150. However, the internal passivation layer 120 and the external passivation layer 140 disposed on the sidewall and upper surface of the electrode 150 may be removed through additional etching. Then, as shown in FIG. 1, the sidewall and upper surface of the electrode 150 may be exposed to the outside. In some embodiments, the internal passivation layer 120 and the external passivation layer 140 disposed on the sidewall and upper surface of the electrode 150 may remain as they are.

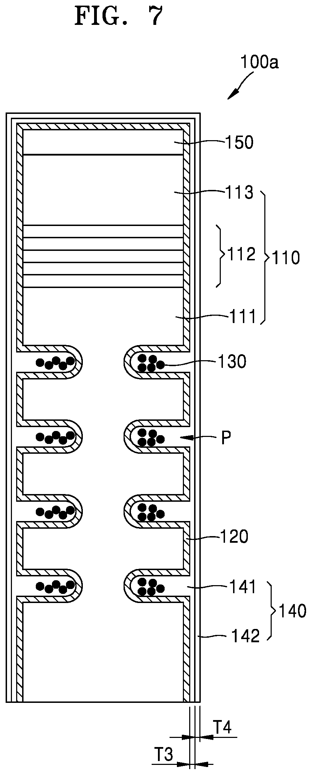

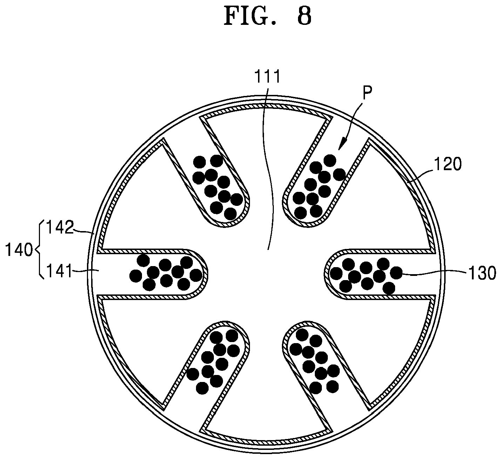

FIG. 7 is a cross-sectional view illustrating a structure of a light emitting device 100a according to an embodiment. FIG. 8 is a transverse cross-sectional view illustrating a structure of the light emitting device 100a shown in FIG. 7 according to an embodiment.

Referring to FIGS. 7 and 8, the external passivation layer 140 of the light emitting device 100a may have a multilayer structure including a plurality of layers. For example, the external passivation layer 140 may include a first external passivation layer 141 surrounding a sidewall of the semiconductor light emitting structure 110 and a sidewall of the internal passivation layer 120, and a second external passivation layer 142 surrounding a sidewall of the first external passivation layer 141. When the internal passivation layer 120 is omitted, the first external passivation layer 141 may be disposed to directly surround (i.e., surround and directly contact) the sidewall of the semiconductor light emitting structure 110. In addition, the first external passivation layer 141 may be disposed to at least partially fill each of the pores P of the first semiconductor layer 111, and may contact at least one of the plurality of quantum dots 130 within each of the pores P. The first external passivation layer 141 and the second external passivation layer 142 may directly contact each other. The remaining structure of the light emitting device 100a shown in FIGS. 7 and 8 may be the same as the structure of the light emitting device 100 shown in FIG. 1, and repeated descriptions may be omitted.

The first external passivation layer 141 and the second external passivation layer 142 may be configured to jointly serve as a wavelength selective transmission layer that selectively reflects the first light L1 of a relatively short wavelength generated from the light emitting layer 112 and selectively transmits the second light L2 of a relatively long wavelength emitted from the quantum dot 130. To this end, the first external passivation layer 141 and the second external passivation layer 142 may have different refractive indices. For example, the first external passivation layer 141 and the second external passivation layer 142 may include different materials of Al₂O₃, HfO₂, SiO₂, TiO₂, ZrO₂, AlN, Si₃N₄, Ta₂O₅, and AlON. A thickness T3 of the first external passivation layer 141 and a thickness T4 of the second external passivation layer 142 may be different from each other or may be the same. In particular, the material and the thickness T3 of the first external passivation layer 141 and the material and the thickness T4 of the second external passivation layer 142 may be selected to reflect the first light L1 of a first wavelength generated in the light emitting layer 112 and transmit the second light L2 of a second wavelength emitted from the quantum dot 130. Here, the thickness T3 of the first external passivation layer 141 and the thickness T4 of the second external passivation layer 142 are measured in a horizontal direction (that is, a radial direction) from the center of the semiconductor light emitting structure 110. In other words, the thickness T3 of the first external passivation layer 141 is a distance between inner and outer sidewalls of the first external passivation layer 141, and the thickness T4 of the second external passivation layer 142 is a distance between inner and outer sidewalls of the second external passivation layer 142.

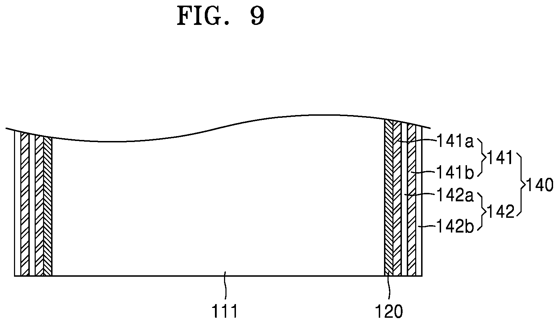

FIG. 9 is a cross-sectional view illustrating a structure of the external passivation layer 140 of a light emitting device according to an embodiment. Referring to FIG. 9, the external passivation layer 140 may include a plurality of first external passivation layers 141a and 141b, and a plurality of second external passivation layers 142a and 142b that are alternately disposed. FIGS. 7 and 8 show that the external passivation layer 140 includes two layers, but is not limited thereto and may include two or more layers to five or less layers. FIG. 9 shows a structure in which the two first external passivation layers 141a and 141b, and the two second external passivation layers 142a and 142b are alternately arranged. For example, the external passivation layer 140 may be a distributed Bragg reflector (DBR) that selectively reflects the first light L1 of a first wavelength and selectively transmits the second light L2 of a second wavelength. According to an embodiment, the material and the thickness T3 of the first external passivation layer 141 and the material and the thickness T4 of the second external passivation layer 142 may be selected such that an interference phenomenon which causes the first light L1 of the first wavelength to be reflected and the second light L2 of the second wavelength to be transmitted occurs at interfaces between the plurality of first external passivation layers 141 and the plurality of second external passivation layers 142.

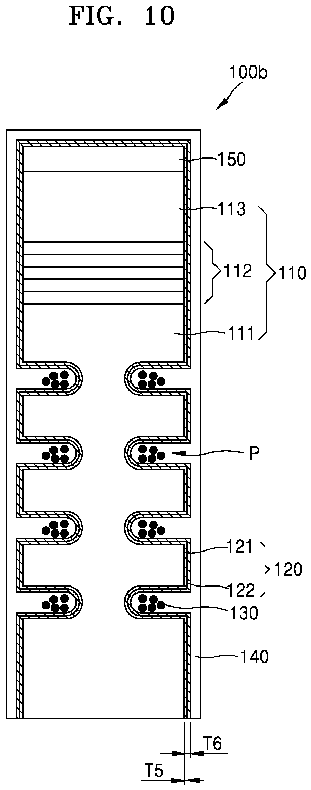

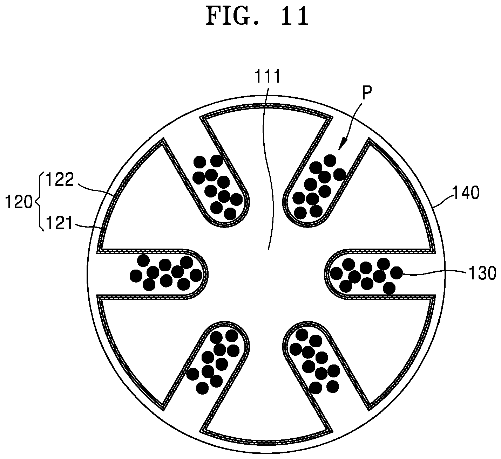

FIG. 10 is a cross-sectional view illustrating a structure of a light emitting device 100b according to an embodiment. FIG. 11 is a transverse cross-sectional view illustrating a structure of the light emitting device 100b shown in FIG. 10 according to an embodiment.

Referring to FIGS. 10 and 11, the internal passivation layer 120 of the light emitting device 100b may have a multilayer structure including a plurality of layers. For example, the internal passivation layer 120 may include a first internal passivation layer 121 surrounding an outer sidewall of the semiconductor light emitting structure 110 and a second internal passivation layer 122 surrounding an outer sidewall of the first internal passivation layer 121. The first internal passivation layer 121 may directly contact the outer surface of the semiconductor light emitting structure 110, and the second internal passivation layer 122 may directly contact the first internal passivation layer 121. Additionally, the second internal passivation layer 122 may directly contact at least one of the plurality of quantum dots 130 and the external passivation layer 140. FIGS. 10 and 11 show that the internal passivation layer 120 includes two layers, but the internal passivation layer 120 is not limited thereto and may include two or more layers to five or less layers. The remaining structure of the light emitting device 100b shown in FIGS. 10 and 11 may be the same as the structure of the light emitting device 100 shown in FIG. 1, or may be the same as the structure of the light emitting device 100a shown in FIGS. 7 to 9, and repeated descriptions may be omitted.

The first internal passivation layer 121 may enhance the crystallinity of the second internal passivation layer 122. The first internal passivation layer 121 may activate a surface of the semiconductor light emitting structure 110 before depositing the second internal passivation layer 122 and remove a surface contamination source through surface modification, thereby enhancing the effect of the second internal passivation layer 122. The first internal passivation layer 121 may be disposed between the semiconductor light emitting structure 110 and the second internal passivation layer 122 such that atoms located on the outer surface of the semiconductor light emitting structure 110 are bonded to atoms of the first internal passivation layer 121, and an atom arrangement in the first internal passivation layer 121 may cause atoms of the second internal passivation layer 122 to be epitaxially arranged. As the crystallinity of the second internal passivation layer 122 increases, dangling bonds on the outer surface of the semiconductor light emitting structure 110 decrease, and surface defects decrease. Accordingly, current may flow relatively uniformly throughout the entire area of the light emitting layer 112 and light emission may occur relatively uniformly throughout the entire area of the light emitting layer 112. Accordingly, the luminous efficiency of the light emitting layer 112 may increase.

The sum of a thickness T5 of the first internal passivation layer 121 and a thickness T6 of the second internal passivation layer 122 may be approximately 0.1 nm or more, approximately 12 nm or less, or approximately 10 nm or less. The thickness T6 of the second internal passivation layer 122 may be the same as the thickness T5 of the first internal passivation layer 121 or may be greater than the thickness T5 of the first internal passivation layer 121. The thickness T5 of the first internal passivation layer 121 and the thickness T6 of the second internal passivation layer 122 are measured in a horizontal direction (that is, a radial direction) from the center of the semiconductor light emitting structure 110. In other words, the thickness T5 of the first internal passivation layer 121 is a distance between inner and outer sidewalls of the first internal passivation layer 121, and the thickness T6 of the second internal passivation layer 122 is a distance between the inner and outer sidewalls of the second internal passivation layer 122.

An energy band gap of each of the first internal passivation layer 121 and the second internal passivation layer 122 may be greater than an energy band gap of the semiconductor light emitting structure 110, and particularly an energy band gap of the light emitting layer 112. Thus, light may be easily generated in the light emitting layer 112 by confining electrons and holes within the semiconductor light emitting structure 110, particularly within the light emitting layer 112. For example, the first internal passivation layer 121 and the second internal passivation layer 122 may include at least one material of Al₂O₃, HfAlOₓ, HfO₂, SiO₂, TiO₂, ZrO₂, AlN, Si₃N₄, Ta₂O₅, and AlON. The material of the first internal passivation layer 121 and the material of the second internal passivation layer 122 may be the same as or different from each other. When the first internal passivation layer 121 and the second internal passivation layer 122 include different materials, the energy band gap of the second internal passivation layer 122 may be selected to be greater than the energy band gap of the first internal passivation layer 121. However, when the first internal passivation layer 121 and the second internal passivation layer 122 include the same material, the energy band gap of the second internal passivation layer 122 is the same as the energy band gap of the first internal passivation layer 121.

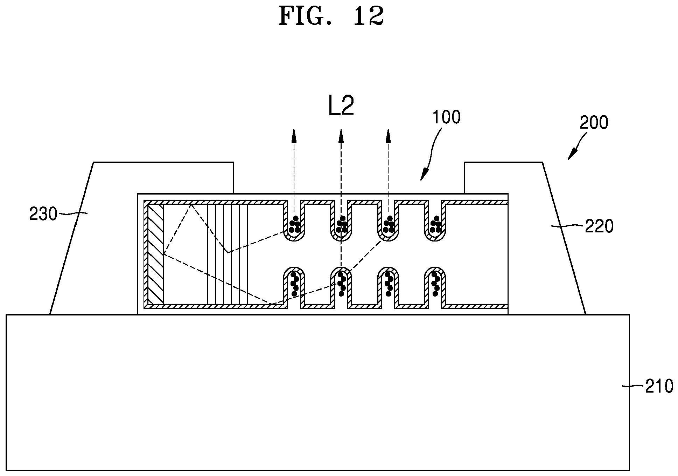

FIG. 12 is a cross-sectional view illustrating a light emitting apparatus 200 including the light emitting device 100 according to an embodiment. Referring to FIG. 12, the light emitting apparatus 200 may include a substrate 210, the light emitting device 100 disposed on the substrate 210, and first and second electrode pads 220 and 230 respectively contacting both ends of the light emitting device 100. FIG. 12 shows the light emitting device 100 shown in FIG. 1, but the light emitting apparatus 200 may be the light emitting device 100a shown in FIGS. 7 to 9 or the light emitting device 100b shown in FIGS. 10 and 11.

The substrate 210 may include a driving circuit driving the light emitting device 100. For example, the substrate 210 may include electronic components such as transistors, capacitors, diodes, resistors, etc. For example, when the light emitting device 100 operates as a pixel of a display apparatus, the substrate 210 may be a display panel including a transistor.

A longitudinal direction of the light emitting device 100 and a thickness direction of the substrate 210 may be perpendicular to each other. For example, as shown in FIG. 12, the light emitting device 100 may be disposed on an upper surface of the substrate 210 such that a sidewall of the semiconductor light emitting structure 110 faces the upper surface of the substrate 210. Then, the second light L2 of a second wavelength converted by the quantum dot 130 in the light emitting device 100 may be emitted in a direction parallel to the thickness direction of the substrate 210 through the internal passivation layer 120 and the external passivation layer 140.

The first and second electrode pads 220 and 230 may be disposed on the substrate 210. The first and second electrode pads 220 and 230 may be spaced apart from each other with the light emitting device 100 disposed therebetween. The first electrode pad 220 may be electrically connected to the first semiconductor layer 111, and the second electrode pad 230 may be electrically connected to the second semiconductor layer 113. For example, the first electrode pad 220 may be disposed to partially surround the first semiconductor layer 111, and the second electrode pad 230 may be disposed to partially surround the electrode 150 and the second semiconductor layer 113.

The first electrode pad 220 may include a metal material with excellent conductivity and reflectivity. For example, the first electrode pad 220 may include at least one of Au, Ag, Cu, Zn, Al, In, Ti, Si, Ge, Sn, Mg, Ta, Cr, W, Ru, Rh, Ir, Ni, Pd, and Pt. Then, the first electrode pad 220 may reflect the first light L1 and/or the second light L2 incident from the first semiconductor layer 111, thereby preventing the first light L1 and/or the second light L2 from emitting in a direction perpendicular to the thickness direction of the substrate 210 (that is, in a direction parallel to an upper surface of the substrate 210). Accordingly, the second light L2 may be emitted in a direction parallel to the thickness direction of the substrate 210.

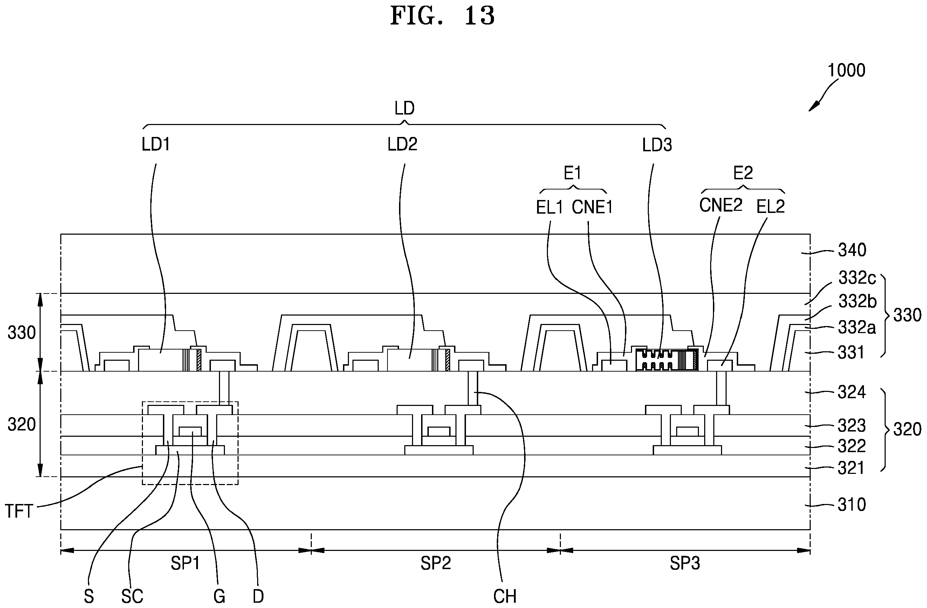

FIG. 13 is a diagram illustrating a display apparatus 1000 including light emitting devices according to an embodiment. Referring to FIG. 13, the display apparatus 1000 may include a substrate 310 in which a plurality of pixels are provided. Each of the plurality of pixels may include a first sub pixel SP1, a second sub pixel SP2, and a third sub pixel SP3 provided on the substrate 310. The first to third sub pixels SP1, SP2, and SP3 may be a pixel region displaying an image in one pixel and may be a light emitting region from which light is emitted. Each of the first to third sub pixels SP1, SP2, and SP3 may include a substrate 310, a driving device layer 320, a display apparatus layer 330, and an overcoat layer 340.

The substrate 310 may include an insulating material such as glass, organic polymer, or quartz. In addition, the substrate 310 may be made of a material having flexibility so as to be bent or folded, and may have a single-layer structure or a multilayer structure. The driving device layer 320 may include a buffer layer 321 disposed on the substrate 310, a transistor TFT disposed on the buffer layer 321, and a driving voltage wiring. The buffer layer 321 may prevent impurities from diffusing into the transistor TFT. The buffer layer 321 may be provided as a single layer, but may be provided as multiple layers more than or equal to at least a double layer. When the buffer layer 321 is provided as multiple layers, each layer may be made of the same material or different materials. The buffer layer 321 may be omitted depending on the material and process conditions of the substrate 310.

The transistor TFT may drive the corresponding light emitting device among a plurality of light emitting devices LD1, LD2, and LD3 included in the display apparatus layer 330. The transistor TFT may include a semiconductor layer SC, a gate electrode G, a source electrode S, and a drain electrode D. The semiconductor layer SC may be disposed on the buffer layer 321. The semiconductor layer SC may include a source region contacting the source electrode S and a drain region contacting the drain electrode D. A region between the source region and the drain region may be a channel region. The semiconductor layer SC may be a semiconductor pattern made of polysilicon, amorphous silicon, oxide semiconductor, etc. The channel region is a semiconductor pattern that is not doped with impurities, and may be an intrinsic semiconductor. The source region and the drain region may be semiconductor patterns doped with impurities. The gate electrode G may be provided on the semiconductor layer SC with a gate insulating layer 322 disposed therebetween. The source electrode S and the drain electrode D may respectively contact the source region and the drain region of the semiconductor layer SC through a contact hole penetrating an interlayer insulating layer 323 and a gate insulating layer 322.

A passivation layer 324 may be provided on the transistor TFT. The display apparatus layer 330 may include the plurality of light emitting devices LD1, LD2, and LD3 provided on the passivation layer 324. For example, the first sub pixel SP1 may include a first light emitting device LD1, the second sub pixel SP2 may include a second light emitting device LD2, and the third sub pixel SP3 may include a third light emitting device LD3. The first to third light emitting devices LD1, LD2, and LD3 may emit lights of different wavelengths. The first light emitting device LD1 in the first sub pixel SP1 may emit blue light, the second light emitting device LD2 in the second sub pixel SP2 may emit green light, and the third light emitting device LD3 in the third sub pixel SP3 may emit red light. For example, the first light emitting device LD1 may emit light of a wavelength of about 420 nm to about 495 nm, the second light emitting device LD2 may emit light of a wavelength of about 495 nm to about 570 nm, and the third light emitting device LD3 may emit light of a wavelength of about 620 nm to about 750 nm, but the disclosure is not limited thereto.

At least two of the first to third light emitting devices LD1, LD2, and LD3 may include a light emitting layer that generates light of the same wavelength. For example, a light emitting layer included in the first light emitting layer LD1 and a light emitting layer included in the third light emitting layer LD3 may generate first light (i.e., blue light) of a first wavelength. In addition, quantum dots included in the third light emitting layer LD3 may convert blue light into second light (i.e., red light) of a second wavelength longer than the first wavelength. For example, the third light emitting device LD3 may be the light emitting device 100 shown in FIG. 1, the light emitting device 100a shown in FIGS. 7 to 9, or the light emitting device 100b shown in FIGS. 10 and 11.

The display apparatus layer 330 may further include a pixel defining layer 331. The pixel defining layer 331 may be provided on the passivation layer 324, and may partition a light emitting region in each of the first to third sub pixels SP1, SP2, and SP3. In other words, the pixel defining layer 331 may include an opening exposing the first to third light emitting devices LD1, LD2, and LD3 respectively included in the first to third sub pixels SP1, SP2, and SP3. A first insulating layer 332a may be provided on the pixel defining layer 331. The first insulating layer 332a may cover a part of an upper surface of each of the first to third light emitting devices LD1, LD2, and LD3 respectively provided in the first to third sub pixels SP1, SP2, and SP3.

In addition, the display apparatus 1000 may include a plurality of first electrodes E1 and a plurality of second electrodes E2. The first and second electrodes E1 and E2 may be disposed on the passivation layer 324. The first electrode E1 may include a first sub electrode EL1 disposed adjacent to one end (e.g., a first semiconductor layer) of the corresponding light emitting device, and a first contact electrode CNE1 electrically connecting the first sub electrode EL1 to one end of the corresponding light emitting device. The second electrode E2 may include a second sub electrode EL2 disposed adjacent to the other end (e.g., a second semiconductor layer) of the corresponding light emitting device and a second contact electrode CNE2 electrically connecting the second sub electrode EL2 to one end of the corresponding light emitting device. The first and second contact electrodes CNE1 and CNE2 may respectively correspond to the first and second electrode pads 220 and 230 of FIG. 12.

A second insulating layer 332b and a third insulating layer 332c may be provided on the first and second electrodes E1 and E2. An overcoat layer 340 may be provided on the third insulating layer 332c. The overcoat layer 340 may be a planarization layer that alleviates a step difference caused by the components disposed therebelow. In addition, the overcoat layer 340 may be an encapsulation layer that prevents oxygen and moisture from penetrating into the first to third light emitting devices LD1, LD2, and LD3.

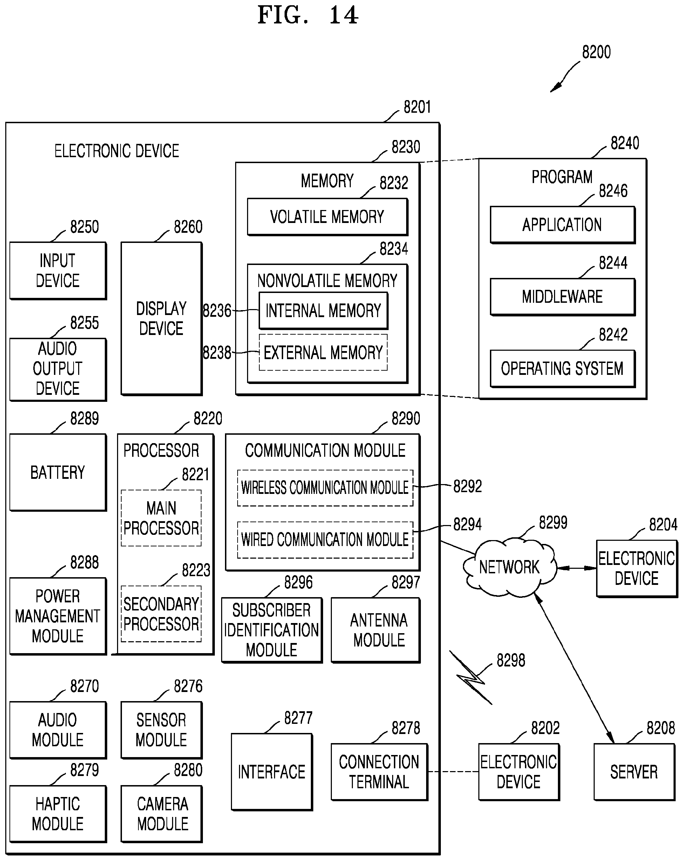

The light emitting devices 100, 100a, and 100b according to the above-described embodiments may be applied to display apparatuses of various sizes and uses without limitation. In addition, the display apparatus described above may be applied to various electronic devices. For example, FIGS. 14 to 19 show various applications of electronic devices and display apparatuses.

FIG. 14 is a block diagram of an electronic device 8201 according to an embodiment. Referring to FIG. 14, the electronic device 8201 may be provided in a network environment 8200. In the network environment 8200, the electronic device 8201 may communicate with another electronic device 8202 through a first network 8298 (such as a short-range wireless communication network, and the like), or communicate with another electronic device 8204 and/or a server 8208 through a second network 8299 (such as a remote wireless communication network). The electronic device 8201 may communicate with the electronic device 8204 through the server 8208. The electronic device 8201 may include a processor 8220, a memory 8230, an input device 8250, an audio output device 8255, a display apparatus 8260, an audio module 8270, a sensor module 8276, and an interface 8277, a haptic module 8279, a camera module 8280, a power management module 8288, a battery 8289, a communication module 8290, a subscriber identification module 8296, and/or an antenna module 8297. In the electronic device 8201, some of these components may be omitted or other components may be added. Some of these components may be implemented as one integrated circuit. For example, the sensor module 8276 (fingerprint sensor, iris sensor, illuminance sensor, etc.) may be implemented by being embedded in the display apparatus 8260 (display, etc.).

The processor 8220 may execute software (the program 8240, etc.) to control one or a plurality of other components (such as hardware, software components, etc.) of the electronic device 8201 connected to the processor 8220, and perform various data processing or operations. As part of data processing or operation, the processor 8220 may load commands and/or data received from other components (the sensor module 8276, the communication module 8290, etc.) into the volatile memory 8232, process commands and/or data stored in the volatile memory 8232, and store result data in the nonvolatile memory 8234. The nonvolatile memory 8234 may include an internal memory 8236 mounted in the electronic device 8201 and a removable external memory 8238. The processor 8220 may include a main processor 8221 (such as a central processing unit, an application processor, etc.) and a secondary processor 8223 (such as a graphics processing unit, an image signal processor, a sensor hub processor, a communication processor, etc.) that may be operated independently or together. The secondary processor 8223 may use less power than the main processor 8221 and may perform specialized functions.

The secondary processor 8223 may control functions and/or states related to some of the components of the electronic device 8202 (such as the display apparatus 8260, the sensor module 8276, the communication module 8290, etc.) instead of the main processor 8221 while the main processor 8221 is in an inactive state (sleep state), or with the main processor 8221 while the main processor 8221 is in an active state (application execution state). The secondary processor 8223 (such as an image signal processor, a communication processor, etc.) may be implemented as part of other functionally related components (such as the camera module 8280, the communication module 8290, etc.).

The memory 8230 may store various data required by components of the electronic device 8201 (such as the processor 8220, the sensor module 8276, etc.). The data may include, for example, software (such as the program 8240, etc.) and input data and/or output data for commands related thereto. The memory 8230 may include a volatile memory 8232 and/or a nonvolatile memory 8234.

The program 8240 may be stored as software in the memory 8230 and may include an operating system 8242, a middleware 8244, and/or an application 8246.

The input device 8250 may receive commands and/or data to be used for components (such as the processor 8220, etc.) of the electronic device 8201 from outside (a user) of the electronic device 8201. The input device 8250 may include a remote controller, a microphone, a mouse, a keyboard, and/or a digital pen (such as a stylus pen).

The audio output device 8255 may output an audio signal to the outside of the electronic device 8201. The audio output device 8255 may include a speaker and/or a receiver. The speaker may be used for general purposes such as multimedia playback or recording playback, and the receiver may be used to receive incoming calls. The receiver may be combined as a part of the speaker or may be implemented as an independent separate device.

The display apparatus 8260 may visually provide information to the outside of the electronic device 8201. The display apparatus 8260 may include a display, a hologram device, or a projector and a control circuit for controlling the device. The display apparatus 8260 may include the above-described driving circuit, micro semiconductor light emitting device, side reflection structure, bottom reflection structure, and the like. The display apparatus 8260 may include a touch circuit set to sense a touch, and/or a sensor circuit (such as a pressure sensor) set to measure the strength of a force generated by the touch.

The audio module 8270 may convert sound into an electrical signal, or conversely, may convert an electrical signal into sound. The audio module 8270 may acquire sound through the input device 8250 or output sound through speakers and/or headphones of the audio output device 8255, and/or another electronic device (such as the electronic device 8102) directly or wirelessly connected to electronic device 8201.

The sensor module 8276 may detect an operating state (such as power, temperature, and the like) of the electronic device 8201 or an external environmental state (such as a user state, and the like), and generate an electrical signal and/or data value corresponding to the detected state. The sensor module 8276 may include a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 8277 may support one or more specified protocols that may be used for the electronic device 8201 to connect directly or wirelessly with another electronic device (such as the electronic device 8102). The interface 8277 may include a high definition multimedia interface (HDMI), a universal serial bus (USB) interface, a secure digital (SD) card interface, and/or an audio interface.

The connection terminal 8278 may include a connector through which the electronic device 8201 may be physically connected to another electronic device (such as the electronic device 8102). The connection terminal 8278 may include an HDMI connector, a USB connector, an SD card connector, and/or an audio connector (such as a headphone connector).

The haptic module 8279 may convert an electrical signal into a mechanical stimulus (such as vibration, movement, etc.) or an electrical stimulus that a user may perceive through a tactile or motor sense. The haptic module 8279 may include a motor, a piezoelectric element, and/or an electrical stimulation device.

The camera module 8280 may capture a still image and a video. The camera module 8280 may include a lens assembly including one or more lenses, image sensors, image signal processors, and/or flashes. The lens assembly included in the camera module 8280 may collect light emitted from a subject that is a target of image capturing.

The power management module 8288 may manage power supplied to the electronic device 8201. The power management module 8388 may be implemented as a part of a power management integrated circuit (PMIC).

The battery 8289 may supply power to components of the electronic device 8201. The battery 8289 may include a non-rechargeable primary cell, a rechargeable secondary cell, and/or a fuel cell.

The communication module 8290 may support establishing a direct (wired) communication channel and/or a wireless communication channel, and performing communication through the established communication channel between the electronic device 8201 and other electronic devices (such as the electronic device 8102, the electronic device 8104, the server 8108, and the like). The communication module 8290 may include one or more communication processors that operate independently of the processor 8220 (such as an application processor) and support direct communication and/or wireless communication. The communication module 8290 may include a wireless communication module 8292 (such as a cellular communication module, a short-range wireless communication module, a global navigation satellite system (GNSS) communication module, and the like) and/or a wired communication module 8294 (such as a local area network (LAN) communication module, a power line communication module, and the like). Among these communication modules, a corresponding communication module may communicate with other electronic devices through a first network 8298 (a short-range communication network such as Bluetooth, WiFi Direct, or infrared data association (IrDA)) or a second network 8299 (a cellular network, the Internet, or a telecommunication network such as a computer network (such as LAN, wide area network (WAN), and the like)). These various types of communication modules may be integrated into one component (such as a single chip, and the like), or may be implemented as a plurality of separate components (a plurality of chips). The wireless communication module 8292 may check and authenticate the electronic device 8201 in a communication network such as the first network 8298 and/or the second network 8299 using the subscriber information (such as international mobile subscriber identifier (IMSI), etc.) stored in the subscriber identification module 8296.

The antenna module 8297 may transmit signals and/or power to the outside (such as other electronic devices) or receive signals and/or power from the outside. The antenna may include a radiator made of a conductive pattern formed on a substrate (such as a printed circuit board (PCB), etc.). The antenna module 8297 may include one or a plurality of antennas. If multiple antennas are included, an antenna suitable for a communication method used in a communication network such as the first network 8298 and/or the second network 8299 may be selected from the plurality of antennas by the communication module 8290. Signals and/or power may be transmitted or received between the communication module 8290 and another electronic device through the selected antenna. In addition to the antenna, other components (such as a radio frequency integrated circuit (RFIC)) may be included as part of the antenna module 8297.

Some of the components are connected to each other and may exchange signals (such as commands, data, and the like) through communication method between peripheral devices (such as bus, general purpose input and output (GPIO), serial peripheral interface (SPI), mobile industry processor interface (MIPI), and the like).

The command or data may be transmitted or received between the electronic device 8201 and the external electronic device 8204 through the server 8108 connected to the second network 8299. The other electronic devices 8202 and 8204 may be the same or different types of devices as or from the electronic device 8201. All or some of the operations executed by the electronic device 8201 may be executed by one or more of the other electronic devices 8202, 8204, and 8208. For example, when the electronic device 8201 needs to perform a certain function or service, instead of executing the function or service itself, the electronic device 8201 may request one or more other electronic devices to perform the function or part or all of the service. One or more other electronic devices that receive the request may execute an additional function or service related to the request, and transmit a result of the execution to the electronic device 8201. For this, cloud computing, distributed computing, and/or client-server computing technology may be used.

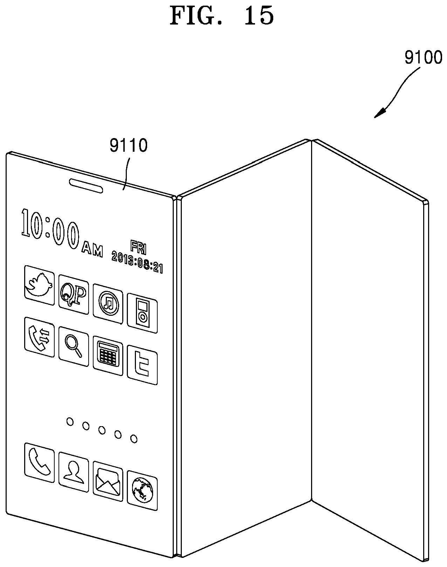

FIG. 15 is a diagram illustrating an example in which a display apparatus 9110 is applied to a mobile device 9100 according to an embodiment. The mobile device 9100 may include the display apparatus 9110, and the display apparatus 9110 may include the above-described driving circuit, micro semiconductor light emitting device, side reflection structure, bottom reflection structure, and the like. The display apparatus 9110 may have a foldable structure, for example, a multi-foldable structure.

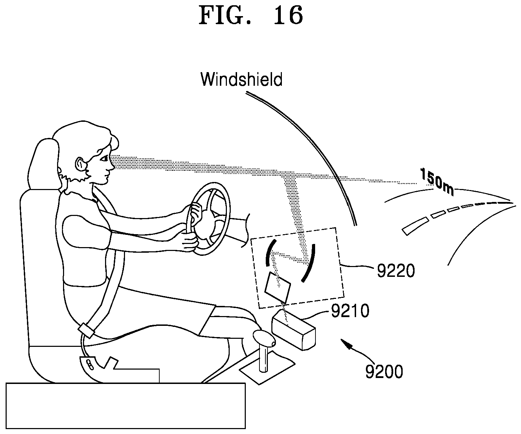

FIG. 16 is a diagram illustrating an example in which a display apparatus 9200 is applied to a vehicle according to an embodiment. The display apparatus 9200 may be a vehicle head-up display apparatus 9200, and may include a display 9210 provided in an area of the vehicle, and a light path changing member 9220 that converts an optical path such that the driver may see the image generated on the display 9210.

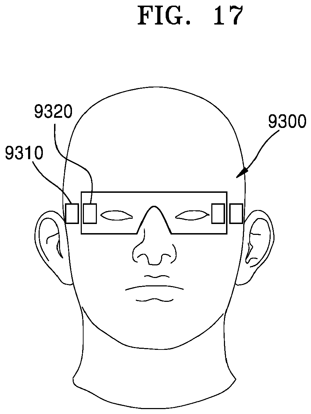

FIG. 17 is a diagram illustrating an example in which a display apparatus is applied to augmented reality glasses 9300 or virtual reality glasses according to an embodiment. The augmented reality glasses 9300 may include a projection system 9310 that forms an image, and an element 9320 that guides the image from the projection system 9310 into the user's eye. The projection system 9310 may include the above-described light emitting device and other components described above.

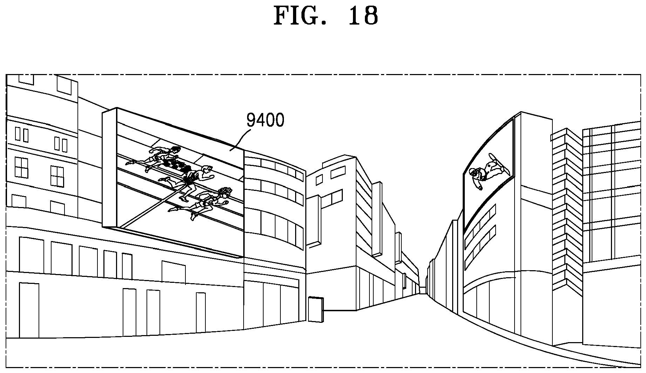

FIG. 18 is a diagram illustrating an example in which a display apparatus is applied to a signage 9400 according to an embodiment. The signage 9400 may be used for outdoor advertisement using a digital information display, and may control advertisement contents and the like through a communication network. The signage 9400 may be implemented, for example, through the electronic device described with reference to FIG. 14.

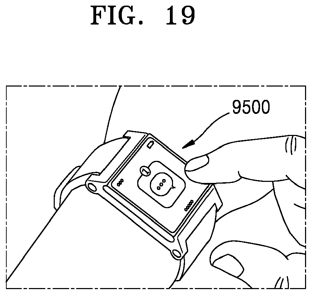

FIG. 19 is a diagram illustrating an example in which a display apparatus is applied to a wearable display 9500 according to an embodiment. The wearable display 9500 may include the semiconductor light emitting device and other components described above, and may be implemented through the electronic device described with reference to FIG. 14.

The display apparatus according to the embodiment may also be applied to various products such as a rollable television (TV) and a stretchable display.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A light emitting device comprising:
a semiconductor light emitting structure comprising:
a first semiconductor layer comprising a plurality of pores;
a light emitting layer provided on the first semiconductor layer; and
a second semiconductor layer provided on the light emitting layer;
a plurality of quantum dots provided in the plurality of pores; and
an external passivation layer at least partially surrounding a sidewall of the semiconductor light emitting structure,
wherein the plurality of quantum dots are provided between the plurality of pores and the external passivation layer.

2. The light emitting device of claim 1, further comprising an internal passivation layer at least partially surrounding the sidewall of the semiconductor light emitting structure and provided on inner surfaces of the plurality of pores,
wherein the external passivation layer at least partially surrounds a sidewall of the internal passivation layer, and
wherein the plurality of quantum dots are provided between the internal passivation layer and the external passivation layer.

3. The light emitting device of claim 2, wherein the internal passivation layer comprises an insulating crystal having an epitaxial structure.

4. The light emitting device of claim 3, wherein the internal passivation layer comprises at least one of Al₂O₃, HfAlOₓ, HfO₂, SiO₂, TiO₂, ZrO₂, AlN, Si₃N₄, Ta₂O₅, and AlON.

5. The light emitting device of claim 3, wherein the internal passivation layer has a lattice matching epitaxy relationship or a domain matching epitaxy relationship with the semiconductor light emitting structure.

6. The light emitting device of any of claims 2 to 5, wherein a thickness of the internal passivation layer is 0.1 nm or more and 12 nm or less.

7. The light emitting device of any of claims 2 to 6, wherein the internal passivation layer comprises a first internal passivation layer at least partially surrounding the sidewall of the semiconductor light emitting structure and a second internal passivation layer at least partially surrounding a sidewall of the first internal passivation layer,
wherein the first internal passivation layer contacts an outer surface of the semiconductor light emitting structure, and
wherein the second internal passivation layer contacts the first internal passivation layer, at least one quantum dot of the plurality of quantum dots, and the external passivation layer.

8. The light emitting device of claim 7, wherein an energy band gap of the first internal passivation layer is greater than an energy band gap of the semiconductor light emitting structure, and
wherein an energy band gap of the second internal passivation layer is greater than or equal to the energy band gap of the first internal passivation layer.

9. The light emitting device of any of claims 2 to 8, wherein the light emitting layer is configured to generate first light of a first wavelength, and
wherein the plurality of quantum dots are configured to:
absorb the first light of the first wavelength; and
emit second light of a second wavelength that is longer than the first wavelength, and optionally wherein the internal passivation layer and the external passivation layer are configured as a wavelength selective transmission layer that selectively reflects the first light and selectively transmits the second light.

10. The light emitting device of claim 9, wherein the external passivation layer comprises a first external passivation layer at least partially surrounding the sidewall of the semiconductor light emitting structure and a second external passivation layer at least partially surrounding a sidewall of the first external passivation layer, and optionally wherein the first external passivation layer and the second external passivation layer are configured as a wavelength selective transmission layer that selectively reflects the first light and selectively transmits the second light.

11. The light emitting device of claim 9, wherein the external passivation layer comprises a plurality of first external passivation layers and a plurality of second external passivation layers that are alternately provided, and
wherein the plurality of first external passivation layers have different refractive indices from the plurality of second external passivation layers, and optionally wherein the external passivation layer is a distributed Bragg reflector configured to selectively reflect the first light and selectively transmit the second light.

12. The light emitting device of any preceding claim, wherein the external passivation layer comprises a material capable of being deposited at a temperature of less than 180 °C, and wherein the external passivation layer comprises at least one of Al₂O₃, HfO₂, SiO₂, TiO₂, ZrO₂, AlN, Si₃N₄, Ta₂O₅, and AlON.

13. The light emitting device of any preceding claim, wherein a thickness of the external passivation layer is 1 nm or more and 100 nm or less.

14. The light emitting device of any preceding claim, wherein the external passivation layer at least partially fills an inside of each of the plurality of pores of the first semiconductor layer.

15. A display apparatus comprising:
a first light emitting device, a second light emitting device, and a third light emitting device that are configured to emit light of different wavelengths,
the third light emitting device according to any preceding claim
wherein a light emitting layer of the first light emitting device and the light emitting layer of the third light emitting device are configured to generate first light of a first wavelength, and
wherein the plurality of quantum dots are configured to absorb the first light of the first wavelength generated by the light emitting layer of the third light emitting device and emit second light of a second wavelength that is longer than the first wavelength, and optionally further comprising a substrate,
wherein a sidewall of the semiconductor light emitting structure of the third light emitting device faces an upper surface of the substrate.
